# EUROPEAN PATENT APPLICATION

(11) **EP 4 421 853 A1**
(43) Date of publication of application: **28.08.2024**
(21) Application number: 22882729.1
(22) Date of filing: 13.10.2022
(51) Int. Cl.: H01L 21/67, H01L 21/677, H01L 21/683

(54) **PROCESS CHAMBER, SEMICONDUCTOR PROCESS DEVICE, AND SEMICONDUCTOR PROCESS METHOD**

(30) Priority: 20.10.2021 CN 202111219963
(71) Applicant: Beijing NAURA Microelectronics Equipment Co., Ltd., Beijing 100176 (CN)
(72) Inventor: CHI, Wenkai, Beijing 100176 (CN); WANG, Yongfei, Beijing 100176 (CN)
(74) Representative: Cohausz & Florack
(86) International application number: PCT/CN2022/125007
(87) International publication number: WO 2023/066119

(57) **Abstract**

The present disclosure provides a processing chamber applied to semiconductor processing equipment, including a transfer chamber and a plurality of reaction chambers above the transfer chamber. The plurality of reaction chambers are all communicatively connected to the transfer chamber through bottom openings. A plurality of bases can ascend and descend between the reaction chambers and the transfer chamber. The processing chamber further includes a transfer mechanism and a carrier mechanism arranged in the transfer chamber. The transfer mechanism is configured to transfer wafers from outside the processing chamber to the carrier mechanism or onto the plurality of bases, and to transfer the wafers on the plurality of bases out of the processing chamber. The carrier mechanism is configured to carry the plurality of wafers and can transfer the plurality of wafers carried by the carrier mechanism onto the plurality of bases. In the present disclosure, the transfer mechanism can first transfer a next batch of wafers onto the carrier mechanism, and the carrier mechanism transfers the wafers carried by the carrier mechanism onto the bases after the semiconductor processing is completed, which saves wafer transfer time. The present disclosure also provides the semiconductor processing equipment and a semiconductor processing method.

## Description

### TECHNICAL FIELD

The present disclosure generally relates to the semiconductor processing equipment field and, more particularly, to a processing chamber, semiconductor processing equipment including the processing chamber, and a semiconductor processing method implemented through the processing chamber.

### BACKGROUND

In recent years, with the rapid development of the semiconductor industry, the trend of miniaturization of electronic devices has become increasingly evident. More and more requirements are imposed to process materials at an atomic scale. Atomic layer deposition (ALD) technology, especially plasma-enhanced atomic layer deposition (PEALD) technology, has become an increasingly prominent topic of interest. The atomic layer deposition technology requires a plurality of reaction gases to enter a chamber continuously and in sequence. Before entering the chamber, the gases must be maintained sequentially and independently in a gas phase to deposit a film layer with a predetermined thickness in the reaction chamber to obtain a thin film with required performance.

Existing atomic layer deposition processing equipment mainly includes a front-end module, a transfer platform, and a processing chamber. A manipulator is provided at the transfer platform and configured to transfer a wafer between the front-end module and the processing chamber. With an increasing requirement for PEALD processing capacity, to improve the capacity of the equipment, the processing chamber has a multi-chamber structure. That is, a plurality of reaction chambers are configured in the processing chamber. Thus, wafers can be loaded to and gases can be supplied to the plurality of reaction chambers simultaneously. The pressures of the plurality of reaction chambers can be controlled simultaneously, which improves the wafer processing efficiency while ensuring the independence of the reaction chambers.

However, the manipulator of the transfer platform is originally configured in cooperation with the processing chamber with a single chamber structure. The wafer transfer efficiency of the existing manipulator cannot satisfy the processing requirements of the multi-chamber structure and becomes a technology bottleneck for improving the capacity of the atomic layer deposition processing equipment.

### SUMMARY

The present disclosure is intended to provide a processing chamber, semiconductor processing equipment, and a semiconductor processing method. With the processing chamber, the wafer transfer time can be saved, and the machine capacity can be improved.

To realize the above purpose, the present disclosure provides a processing chamber applied in semiconductor processing equipment, including a transfer chamber and a plurality of reaction chambers located above the transfer chamber. The plurality of reaction chambers are all communicatively connected to the transfer chamber through bottom openings. The processing chamber further includes a plurality of bases configured to carry wafers. The plurality of bases are in one-to-one correspondence with positions of the plurality of reaction chambers and are capable of ascending and descending between the reaction chambers and the transfer chamber to seal or open the bottom openings. The processing chamber further includes a transfer mechanism and a carrier mechanism arranged in the transfer chamber. The transfer mechanism is configured to transfer a wafer from outside the processing chamber to the carrier mechanism or onto the base and transfer the wafer on the base out of the processing chamber. The carrier mechanism is configured to carry and transfer a plurality of wafers to the plurality of bases.

In some embodiments, the plurality of bases are arranged around the carrier mechanism. The carrier mechanism includes a plurality of wafer-carrying positions. A number of the wafer-carrying positions is consistent with a number of the bases. The carrier mechanism is configured to allow the plurality of wafer-carrying positions to simultaneously approach the plurality of corresponding bases and transfer the plurality of wafers onto the plurality of corresponding bases, or allow the plurality of wafer-carrying positions to simultaneously away from the plurality of bases.

In some embodiments, the carrier mechanism includes a driver, a connector, and a plurality of finger pieces. The wafer-carrying positions are formed on upper surfaces of the finger pieces. The plurality of finger pieces are arranged around the connector. The driver is configured to drive the connector to ascend and descend the plurality of finger pieces and drive the plurality of finger pieces to rotate around a rotation axis of the connector.

In some embodiments, a base includes a plurality of base holes distributed around an axis of the base. A plurality of support columns are arranged in the plurality of base holes in a one-to-one correspondence. The plurality of support columns are configured to descend relative to the base along the plurality of base holes when the base ascends, ascend with the base after top surfaces of the plurality of support columns are not higher than a carrying surface of the base, and support and lift the wafer on the base after the base descends to bottoms of the plurality of support columns and contacts a bottom wall of the transfer chamber.

A finger piece includes a clearance on a side of the finger piece facing the corresponding base, and when the driver drives the connector to drive the plurality of finger pieces to rotate to a position above the plurality of bases in one-to-one correspondence to the plurality finger pieces. The plurality of support columns of each base are in the clearance of the corresponding finger piece.

In some embodiments, a support column includes a position-limiting member. The position-limiting member cooperates with the base hole and is configured to allow the support column to have a fixed relative position with the base when the base ascends and the top surface of the support column is not higher than the carrying surface of the base to allow the support column to ascend with the base.

In some embodiments, two wafer transfer openings are formed on a side wall of the transfer chamber corresponding to the processing chamber. The transfer mechanism is configured to obtain the wafer from outside the processing chamber through the two wafer transfer openings and transfer the wafer out of the processing chamber through the two wafer transfer openings.

In some embodiments, the processing chamber further includes a plurality of sealing rings. The plurality of sealing rings are in one-to-one correspondence with the plurality of bases. The sealing rings are sleeved circumferentially on side walls of the bases. The sealing rings are able to seal the bottom openings of the corresponding reaction chambers when the bases ascend to the corresponding reaction chambers.

In some embodiments, a plurality of sets of annular sealing grooves are formed at a top wall of the transfer chamber in one-to-one correspondence with the bottom openings of the plurality of reaction chambers. A plurality of annular sealing grooves of each set are arranged coaxially and around the corresponding bottom opening. A sealing ring includes an annular positioning surface facing the top wall of the transfer chamber. A plurality of annular protrusions are formed on the annular positioning surface and are arranged coaxially. The plurality of annular protrusions are in one-to-one correspondence with the plurality of annular sealing grooves. When the base ascends to the reaction chamber, the annular protrusions at least partially enter the corresponding annular sealing grooves.

In some embodiments, the transfer mechanism includes a driver, a finger member, and a plurality of swing rods. The plurality of swing rods are sequentially connected between the driver and the finger member. The plurality of swing rods and the swing rods with the driver and the finger member are articulated through articulation shafts. The plurality of articulation shafts extend vertically. The driver is configured to drive the finger member and the plurality of swing rods to rotate around the articulation shafts, respectively, and drive the plurality of swing rods and the finger member to ascend and descend.

As a second aspect of the present disclosure, semiconductor processing equipment is provided, wherein the semiconductor processing equipment includes the processing chamber above.

As a third aspect of the present disclosure, a semiconductor processing method is provided and applied to the processing chamber above. The method includes:
step S 1, controlling the transfer mechanism to transfer the wafers outside the processing chamber onto the plurality of bases;
step S2, controlling the plurality of bases to ascend to the corresponding reaction chambers, and performing semiconductor processing, and simultaneously controlling the transfer mechanism to transfer wafers from outside the processing chamber to the carrier mechanism;
step S3, after the semiconductor processing is completed, controlling the plurality of bases to descend into the transfer chamber, and controlling the transfer mechanism to transfer the wafers on the plurality of bases out of the processing chamber;
step S4, controlling the carrier mechanism to transfer the plurality of wafers carried by the carrier mechanism onto the plurality of bases; and
repeatedly executing steps S2 to S4.

In the processing chamber, semiconductor process equipment, and semiconductor process method of the present disclosure, the transfer mechanism and the carrier mechanism are arranged in the transfer chamber of the processing chamber. The carrier mechanism can temporarily store the wafers. Thus, when the plurality of bases carries the plurality of wafers, respectively, and ascends to the corresponding reaction chambers for synchronous semiconductor processing, the transfer mechanism can transfer the next batch of wafers from outside the processing chamber onto the carrier mechanism. When the semiconductor processing of the previous batch of wafers is completed, the transfer mechanism transfers the wafers out of the processing chamber, and the carrier mechanism then transfers the next batch of wafers carried by the carrier mechanism onto the plurality of bases. Thus, compared to the existing technology the next batch of wafers needs to be transferred to the bases in sequence between the steps of performing the semiconductor processing on the two neighboring batches of wafers, the wafer transfer time is saved, and the machine capacity is improved.

Furthermore, the transmission and positioning of the wafers are implemented by the transfer mechanism and the carrier mechanism in the transfer chamber. A transfer platform with a manipulator is not needed outside the processing chamber. The side of the wafer transfer opening of the processing chamber can be aligned with the loadlock directly to cause the entire structure of the semiconductor processing equipment to be more compact, which reduces the area occupied by the equipment and improves the economic benefits of the semiconductor production line.

### BRIEF DESCRIPTION OF THE DRAWINGS

FIG. 1 illustrates a schematic structural diagram of a processing chamber according to a first embodiment of the present disclosure.
FIG. 2 illustrates a schematic locally enlarged diagram of a processing chamber according to the first embodiment of the present disclosure.
FIG. 3 illustrates a schematic structural diagram of a base of a processing chamber according to the first embodiment of the present disclosure.
FIG. 4A illustrates a schematic diagram showing relative positions among a carrier mechanism, a transfer mechanism, and a base of a processing chamber in a transfer chamber according to a second embodiment of the present disclosure.
FIG. 4B illustrates a schematic structural diagram of a processing chamber when a relative position of a base and a support column is fixed according to the second embodiment of the present disclosure.
FIG. 5 illustrates a schematic structural diagram showing a portion of a transfer mechanism of a processing chamber according to a third embodiment of the present disclosure.
FIG. 6 illustrates a schematic principle diagram showing a transfer mechanism of a processing chamber obtaining a wafer outside the processing chamber according to the third embodiment of the present disclosure.
FIG. 7 illustrates a schematic principle diagram showing a transfer mechanism placing a wafer on a carrier mechanism in a processing chamber according to a fourth embodiment of the present disclosure.
FIG. 8 illustrates a schematic structural diagram of semiconductor processing equipment according to a fourth embodiment of the present disclosure.

### DETAILED DESCRIPTION OF THE EMBODIMENTS

Specific embodiments of the present disclosure are described in detail below in conjunction with the accompanying drawings. It should be understood that the described specific embodiments are only for illustrating and explaining the present disclosure and are not used to limit the present disclosure.

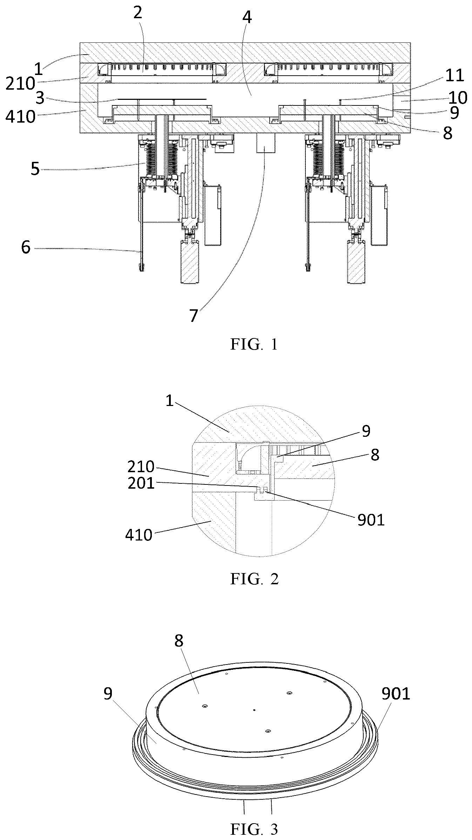

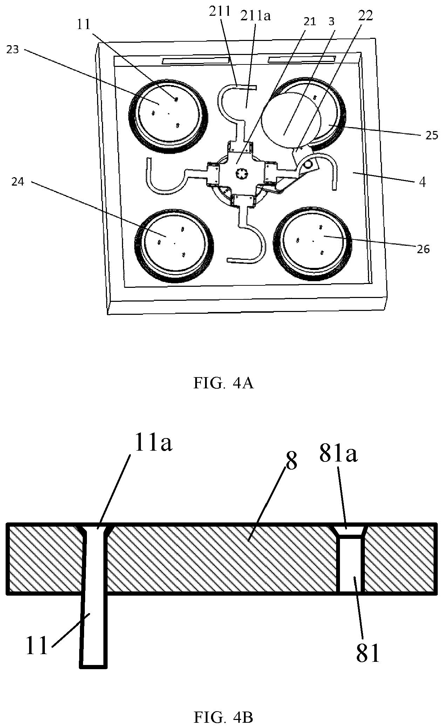

To solve the above technical problem, as one aspect of the present disclosure, a processing chamber applied to semiconductor processing equipment can be provided. As shown in FIG. 1 and FIG. 4A, the processing chamber includes a transfer chamber 4 and a plurality of reaction chambers 2 located above the transfer chamber 4. The plurality of reaction chambers 2 are communicated with the transfer chamber 4 through bottom openings. The processing chamber further includes a plurality of bases 8 configured to carry wafers. The bases 8 are arranged in the transfer chamber 4. The plurality of bases 8 are in one-to-one correspondence with the positions of the plurality of reaction chambers 2. The plurality of bases 8 can ascend and descend between the reaction chambers 2 and the transfer chamber 4 and seal or open the bottom openings corresponding to the reaction chambers 2. The processing chamber further includes a manipulator assembly 7. The manipulator assembly 7 includes a transfer mechanism 22 and a carrier mechanism 21 arranged in the transfer chamber 4. Execution members of the transfer mechanism 22 and the carrier mechanism 21 configured to carry and transfer the wafers are located in the transfer chamber 4. Drive members of the transfer mechanism 22 and the carrier mechanism 21 configured to drive the execution embers can be, for example, arranged under the transfer chamber 4 and can be fixedly connected to a bottom wall of the transfer chamber 4 (in FIG. 1, the execution member of the manipulator assembly 7 located in the transfer chamber is not showed). Thus, an occupied space of the transfer chamber 4 can be reduced. However, embodiments of the present disclosure are not limited to this. In practical applications, the transfer mechanism 22 and the carrier mechanism 21 can be arranged in the transfer chamber 4 as a whole as needed.

The transfer mechanism 22 can be configured to transfer a wafer from the outside of the processing chamber to the carrier mechanism 21 or the base 8 and to transfer a wafer on the base 8 out of the processing chamber. The carrier mechanism 21 can be configured to carry a plurality of wafers and transfer the plurality of wafers carried by the carrier mechanism 21 to the plurality of bases 8. It is easy to understand that before the carrier mechanism 21 transfers the plurality of wafers carried by the carrier mechanism 21 to the plurality of bases 8, it needs to be ensured that no wafer is on the bases 8.

The inventor found through research that in the existing technology, a wafer transfer function is independently implemented by the manipulator of the transfer platform. After the semiconductor processing is performed on a current batch of wafers (each batch of wafers refers to a plurality of wafers on the plurality of bases processed synchronously), the manipulator can fetch the wafers on the plurality of bases in the processing chamber and bring the wafers out of the processing chamber in sequence. Then, the manipulator can transfer a next batch of wafers into the processing chamber and place the wafers on the bases in sequence.

In the present disclosure, the transfer mechanism 22 and the carrier mechanism 21 can be arranged in the transfer chamber 4. The carrier mechanism 21 can temporarily store a to-be-processed wafer 3. Thus, when the current batch of wafers 3 carried by the plurality of bases 8, respectively, are ascended to corresponding reaction chambers 2, and the semiconductor processing is performed synchronously, the transfer mechanism 22 can first transfer the next batch of wafers from the outside of the processing chamber onto the carrier mechanism 21. When the semiconductor processing of the current batch of wafers 3 ends, the transfer mechanism 22 can transfer the processed wafers 3 out of the processing chamber. Then, the carrier mechanism 21 can transfer the next batch of wafers carried by the carrier mechanism 21 onto the plurality of bases 8. Compared to the existing technology, between the steps of performing the semiconductor processing on the neighboring batches of wafers in the existing technology, the operation time of transferring the next batch of wafers into the processing chamber in sequence and positioning can be adjusted so that the transfer time of the next batch of wafers can overlap the time for performing the semiconductor processing on the current batch of wafers. Thus, the wafer transfer time can be saved, and the equipment capacity can be improved.

Furthermore, the transfer and positioning of the wafer can be implemented by the transfer mechanism 22 and the carrier mechanism 21 in the transfer chamber 4. Thus, the transfer platform with the manipulator may not need to be arranged outside of the processing chamber. A side of a wafer transfer opening 10 of the processing chamber can be directly aligned with a Loadlock (configured to evacuate its own chamber to (near) vacuum after the wafers are received. Thus, the evacuation operation may not need to be performed on the processing chamber after the loadlock is communicated with the processing chamber, and the wafer transfer operation is performed, meanwhile, the loadlock can have a function such as a wafer integrity detection). Thus, the overall structure of the semiconductor processing equipment can be more compact. The area occupied by the equipment can be reduced, and the economic benefits of the semiconductor production line can be improved.

As an embodiment of the present disclosure, as shown in FIG. 1 and FIG. 2, the processing chamber includes an upper cover 1, an upper chamber body 210, and a lower chamber body 410 stacked along a height direction. The plurality of reaction chambers 2 are formed in the upper chamber body 210, and the transfer chamber 4 is formed in the lower chamber 410. The upper cover 1 seals the top openings formed by the plurality of reaction chambers 2 at the top of the upper chamber body 210. A plurality of exhaust channels around the reaction chambers 2 may be formed in the upper chamber body 210. An exhaust assembly can be arranged in the exhaust channels. The exhaust assembly can be communicated with the h corresponding reaction chamber 2 through a plurality of exhaust holes distributed circumferentially. The exhaust assembly can be configured to extract exhaust gas from the reaction chamber 2 and discharge the exhaust gas out of the processing chamber.

As an embodiment of the present disclosure, the processing chamber can include four reaction chambers 2.

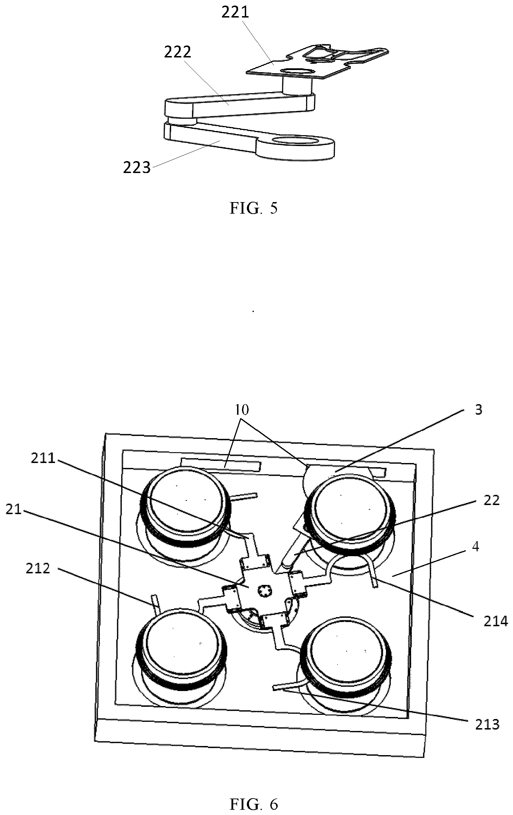

To improve the wafer transfer efficiency of the carrier mechanism 21 to transfer the wafers onto the plurality of bases 8, as a embodiment of the present disclosure, a number of the wafers 3 that can be carried by the carrier mechanism 21 can be the same as a number of the bases 8, and the carrier mechanism 21 can transfer the wafers 3 onto the plurality of bases 8 synchronously. Specifically, as shown in FIG. 4A and FIG. 6, the plurality of bases 8 (for example, including a first base 25, a second base 23, a third base 24, and a fourth base 26) are arranged around the carrier mechanism 21. The carrier mechanism 21 includes a plurality of wafer-carrying positions. A number of the wafer-carrying positions can be consistent with the number of the bases 8, and the carrier mechanism 21 can be configured to allow the plurality of wafer-carrying positions to approach to the plurality of corresponding bases 8 simultaneously and transfer the plurality of wafers onto the plurality of corresponding bases 8, or allow the plurality of wafer-carrying positions to move away from the plurality of corresponding bases 8 simultaneously. Thus, after the wafers are transferred on to the bases 8, the carrier mechanism 21 can avoid the bases 8 to allow the bases 8 to ascend and descend normally.

As an embodiment of the present disclosure, the carrier mechanism 21 can be configured to allow the plurality of wafer-carrying positions to synchronously approach or move away from the bases 8 in a rotation manner. In some embodiments, as shown in FIG. 4A and FIG. 6, the carrier mechanism 21 includes a driver (located below the connector in view angles of FIG. 4A and FIG. 6, which is not shown), a connector, and a plurality of finger pieces (such as four finger pieces, including a finger piece 211, a finger piece 212, a finger piece 213, and a finger piece 214). A wafer-carrying position is formed on the top of a finger piece. The plurality of finger pieces can be fixed around the periphery of the connector. The driver can drive the connector to drive the plurality of finger pieces to ascend and a rotation shaft around the connector to rotate to cause the plurality of finger pieces to approach the plurality of corresponding bases 8 simultaneously and transfer the plurality of wafers onto the plurality of corresponding bases 8, or cause the plurality of finger pieces to move away from the corresponding bases 8 after the plurality of wafers are transferred onto the plurality of corresponding bases 8.

To save space in the processing chamber, as a embodiment of the present disclosure, the driver can be arranged outside the processing chamber and connected to the connector through a drive shaft passing through a through hole at the bottom wall of the transfer chamber 4.

To improve the steadiness of transferring the wafers 3 among the bases 8, finger pieces, and the transfer mechanism 22, as a embodiment of the present disclosure, as shown in FIG. 4, the base 8 includes a plurality of base holes distributed around an axis of the base 8. A plurality of support columns 11 are arranged in the plurality of base holes in a one-to-one correspondence. A support column 11 can be configured to descend relative to the base 8 along the base hole when the base 8 ascends, ascend with the base 8 together after the top surface of the support column 11 is flush with the carrier surface of the base 8, and support and lift the wafer on the base 8 after the base 8 descends to the bottom of the support column 11 and contacts the bottom wall of the transfer chamber 4.

Specifically, when the wafers 8 are transferred between the finger pieces or the transfer mechanism 22 and the bases 8, the bases 8 can be at a lower position, and the top ends of the support columns 11 can extend to be above the carrying surfaces of the bases 8. Thus, when the finger pieces or the transfer mechanism 22 carry and move the wafer to be above the support columns 11 first and then descend to allow the wafer to fall one to the plurality of support columns 11 corresponding to the same base 8. Then, the finger pieces or the transfer mechanism 22 can be removed horizontally. As the base 8 ascends, the support column 11 can retract to a position with the top end lower than or flush with the carrying surface of the base 8 to allow the wafer 3 to steadily fall onto the carrying surface of the base 8.

As a embodiment of the present disclosure, as shown in FIG. 4A and FIG. 4B, to clearly show the structure of the base hole 81. FIG. 4B only illustrates one support column 11. The support column 11 can ascend and descend relative to the base 8. The support column 11 includes a position-limiting member 11a. The position-limiting member 11a cooperates with the base hole 81 and is configured to cause the relative position of the support column 11 and the base 8 to be fixed when the base 8 ascends and the top surface of the support column 11 is not higher than the carrying surface of the base 8 to allow the support column 11 to ascend with the base 8 together. Specifically, when the base 8 ascends, the support column 11 can descend relative to the base 8 under the weight of the support column 11 until the position-limiting member 11a cooperates with the base hole 81. Then, the support column 11 may no longer descend and have a fixed relative position with the base 8. Thus, the support column 11 can ascend with the base 8 together. The position-limiting member 11a can be a position limiting head located at the top end of the support column 11, e.g., a conical platform. A side surface of the conical platform can be a conical position limiting surface narrowing down gradually from the top end. A conical hole segment 81a can be arranged at the hole wall top end of the base hole 81. The hole diameter of the base hole 81 at the conical hole segment 81a can gradually narrow from the carrying surface of the base 8 downward. The position limiting head can enter the conical hole segment 81a and cooperate with the conical hole segment 81a when descending relative to the base 8. Thus, the relative position of the support column 11 and the base 8 can be fixed. Moreover, the top surface of the position limiting head can be lower than or flush with the carrying surface of the base 8 to allow the upper surface of the base 8 to carry the wafer. When the base 8 descends, and the bottom of the support column 11 contacts the bottom wall of the transfer chamber 4 (i.e., the bottom wall of the lower chamber 410), the top end of the support column 11 can be static relative to the transfer chamber 4 and ascend relative to the base 8 that is descending. Thus, when the top end of the support column 11 is higher than the carrying surface of the base 8, the wafer on the base 8 can be lifted up.

To improve the stability of the wafer position, as a embodiment of the present disclosure, as shown in FIG. 4A and FIG. 6, the finger piece 211 is taken as an example. A clearance 211a is formed on one side of the finger piece 211 facing the corresponding base 8. When the driver drives the connector to drive the plurality of finger pieces to rotate to positions where the plurality of finger pieces are located over the plurality of bases 8 in a one-to-one correspondence, the plurality of support columns 11 of each base 8 can be located in clearances 211a of the corresponding finger pieces. As shown in FIG. 4A and FIG. 6, the finger piece is formed in a hook shape to reduce a contact area between the finger piece and the wafer 3. The opening of the hook-shaped finger piece can be the clearance 211a.

In embodiments of the present disclosure, taking the finger piece 211 as an example, the clearance 211a is formed on one side of the finger piece 211 facing the corresponding base 8. Thus, when the wafer 3 is transferred to the base 8, the finger piece 211 can avoid the plurality of support columns 11 of the base 8 radially, which prevents the finger piece 211 from scratching or colliding with the support columns 11 and improves the safety and position stability of the wafer.

Specifically, as shown in FIG. 4A and FIG. 6, for example, the clearances of the plurality of finger pieces face a clockwise direction.

After the transfer mechanism 22 fetches the wafers from the plurality of bases 8, the driver can drive the connector to drive the plurality of finger pieces and the wafers 3 carried by the plurality of finger pieces to ascend to the positions higher than the support columns 11 of the bases 8 and then drive the connector to drive the plurality of finger pieces to rotate clockwise until the wafers 3 of the plurality of finger pieces are aligned with the corresponding bases 8 along the vertical direction. Then, the finger piece 211 can be above the first base 25, the finger piece 212 can be above the second base 23, the finger piece 213 can be above the third base 24, and the finger piece 214 can be above the fourth base 26.

Then, the driver can drive the connector to drive the plurality of finger pieces to descend to positions lower than the top ends of the plurality of support columns 11 and higher than the carrying surfaces of the bases 8 to allow the wafers to fall onto the support columns 11. That is, the wafer 3 carried by the finger piece 211 can fall onto the support columns 11 of the first base 25. The wafer 3 carried by the finger piece 212 can fall onto the support columns 11 of the second base 23. The wafer 3 carried by the finger piece 213 can fall onto the support columns 11 of the third base 24. The wafer 3 carried by the finger piece 214 can fall onto the support columns 11 of the fourth base 26.

Finally, the driver can drive the connector to drive the plurality of finger pieces to rotate counterclockwise to cause the plurality of finger pieces to move away the corresponding bases 8 synchronously to complete the wafer transfer.

As an embodiment of the present disclosure, as shown in FIG. 5, the transfer mechanism 22 includes a driving member (not shown), a finger member 221, and a plurality of swing rods. The plurality of swing rods are connected in sequence between the driving member and the finger member 221. The plurality of swing rods can be articulated through articulation shafts, and the swing rods, the driving member, and the finger member 221 can be articulated through articulation shafts. The plurality of articulation shafts extend along a vertical direction. The driver can be configured to drive the finger member 221 the articulation shafts corresponding to the plurality of swing rods to rotate, respectively, and drive the plurality of swing rods and the finger member 221 to ascend and descend.

To save internal space of the processing chamber, as a embodiment of the present disclosure, the driving member can be arranged outside the processing chamber and connected to the swing rods through the transmission shafts passing through a through-hole at the bottom wall of the transfer chamber. In some embodiments of the present disclosure, the structure of the drive connector in the driver of the carrier mechanism 21, which drives the plurality of finger pieces to ascend and descend, can be integrated with the driving member of the transfer mechanism 22 into the same structure.

In embodiments of the present disclosure, the driving member can be configured to control the height of the finger member 221. Meanwhile, by adjusting angles of the articulation shafts between the plurality of swing rods and between the swing rods and the driving member and the finger member 221, the horizontal position and orientation of the finger member 221 can be controlled. Thus, the finger member 221 can be controlled to carry the wafers to above the finger piece or the support columns 11 of the base 8 in sequence. The finger member 221 can be controlled to descend to allow the wafer 3 to fall onto the support columns 11 of the corresponding finger piece or base 8. Then, the finger member 221 can be controlled to be removed horizontally to implement the wafer transfer.

As an embodiment of the present disclosure, as shown in FIG. 5, the transfer mechanism 22 includes two swing rods such as a first swing rod 222 and the second swing rod 223. A first end of the first swing rod 222 is articulated with a tail end of the finger member 221, a second end of the first swing rod 222 is articulated with a first end of the second swing rod 223. A second end of the second swing rod 223 is articulated with an output shaft of the driving member. The angles at the articulated positions can be automatically adjusted by corresponding driving structures to change the attitude of the transfer mechanism 22.

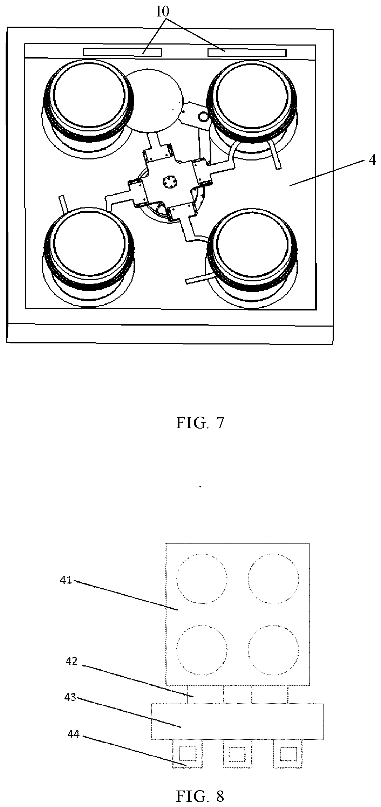

FIG. 6 and FIG. 7 illustrate schematic processes of the transfer mechanism 22 driving the finger member 221 to transfer the wafer to the finger piece. As shown in FIG. 7, during the wafer transfer, the head of the finger member 221 faces the clearance of the corresponding finger piece to avoid scratching and collision between the finger member 221 and the finger piece during an ascending and descending process to enhance the safety and position stability of the wafer.

To improve the wafer transfer efficiency of the transfer mechanism 22, as a embodiment of the present disclosure, as shown in FIG. 4A, FIG. 6, and FIG. 7, the processing chamber corresponds to the two transfer openings 10 formed on the side wall of the transfer chamber 4 (i.e., the side wall of the lower chamber 410). The transfer mechanism 22 can be configured to obtain the wafer outside the processing chamber through the two transfer openings 10 and transfer the wafer out of the processing chamber through the two transfer openings 10.

To improve the seal ability of the reaction chambers 2, as a embodiment of the present disclosure, as shown in FIG. 1 to FIG. 3, the processing chamber also includes a plurality of sealing rings 9. The plurality of sealing rings 9 can be in a one-to-one correspondence with the plurality of bases. A sealing ring 9 is sleeved on the side wall of a corresponding base 8. When the base 8 ascends to the corresponding reaction chamber 2, the sealing ring 9 can seal the bottom opening of the reaction chamber 2.

In embodiments of the present disclosure, the side wall of each base 8 can be sleeved with a sealing ring 9. Thus, when the bases 8 ascend to the corresponding reaction chambers 2, the bottom openings of the corresponding reaction chambers 2 can be sealed by the bases 8 and the sealing rings 9 to form independent processing environments of the reaction chambers 2. According to the processing needs, more than two processes can be implemented in a single processing chamber (i.e., the wafers of the plurality of reaction chambers 2 are performed with different processes), or the plurality of wafers can be performed with a same process in a single processing chamber (i.e., the wafers of the plurality of reaction chambers can be performed with the same process) to further improve the capacity of the equipment.

To further improve the sealing ability of the reaction chambers 2, as a embodiment of the present disclosure, as shown in FIGS. 1 to 3, a plurality of sets of annular sealing grooves 201 in a one-to-one correspondence with the bottom openings of the plurality of reaction chambers 2 are formed at the top wall of the transfer chamber 4. The plurality of annular ring grooves of each set can be coaxial and arranged around the corresponding bottom opening. The sealing ring 9 can have an annular positioning surface facing the top wall of the transfer chamber 4. A plurality of annular protrusions 901 arranged coaxially can be formed on the annular positioning surface. The plurality of annular protrusions 901 can be in a one-to-one correspondence with the plurality of annular sealing grooves 201. When the base 8 ascends to the reaction chamber 2, at least a part of the annular protrusions 901 can end the the corresponding annular sealing grooves 201.

In embodiments of the present disclosure, as the base 8 ascends into the corresponding reaction chamber 2, the plurality of annular protrusions 901 on the sealing ring 9 can also enter the corresponding annular sealing grooves 201. Thus, a labyrinth sealing structure can be formed between the annular positioning surface of the sealing ring 9 and the top wall of the transfer chamber 4, and the sealing ability of the reaction chambers 2 can be further improved. In some embodiments of the present disclosure, the height of the annular protrusions 901 of the sealing ring 9 can be different from the depth of the annular sealing grooves 201 (e.g., the height of the annular protrusions 901 being less than the depth of the annular sealing grooves 201 to ensure that the annular positioning surface of the sealing ring 9 contacts the top wall of the transfer chamber 4) to ensure the effect of the mechanical sealing.

To improve the stability of the axial relative position between the sealing ring 9 and the base 8, and further improve the sealing ability of the reaction chambers 2, as a embodiment of the present disclosure, as shown in FIGS. 1 to 3, an inner convex ridge is formed at the top of the inner wall of the sealing ring 9. The upper surface of the inner convex ridge can be flush with the end surface of the top of the sealing ring 9. An annular positioning groove around the carrying surface of the base 8 can be formed at the top of the base 8. The inner convex ridge can be arranged in the annular positioning groove. The upper surface of the inner convex ridge can be flush with the carrying surface of the base 8. An outer convex ridge is formed at the bottom of the outer wall of the sealing ring 9, and the annular positioning surface is formed at the outer convex ridge.

In embodiments of the present disclosure, the top of the sealing ring 9 can be overlapped with and placed on the top of the base 8 through the inner convex ridge, and the bottom of the sealing ring 9 can contact the top wall of the transfer chamber 4 through the outer convex ridge. Thus, when an ascending and descending device under the base 8 (e.g., a motor 5 in FIG. 1) drives the base 8 to ascend into the reaction chamber 2 through the support shaft, the axial relative position between the sealing ring 9 and the base 8 can be maintained through the cooperation relationship between the inner convex ridge and the annular positioning groove. Thus, the height of the base 8 can be accurately positioned through the inner convex ridge and the outer convex ridge structure.

To improve the cleanliness of the transfer chamber 4, as a embodiment of the present disclosure, the processing chamber can further include a gas pipeline 6. A first processing gauge can be arranged in the plurality of reaction chambers 2, and a second processing gauge can be arranged in the transfer chamber 4. The control device of the semiconductor processing equipment can be configured to detect and compare the gas pressures in the reaction chambers 2 and the transfer chamber 4 through the first processing gauge and the second processing gauge, and control the gas opening and closing of the gas pipeline 6 based on the comparison result of the gas pressures in the reaction chambers 2 and the transfer chamber 4 to cause the gas pressure in the transfer chamber 4 to be greater than the gas pressures in the reaction chambers 2. Thus, the process gas in the reaction chambers 2 can be prevent from flowing into the transfer chamber 4 through the labyrinth sealing structure formed between the annular positioning surface of the sealing ring 9 and the top wall of the transfer chamber 4 or the gaps between the support columns 11 and the base holes, which eliminates particle sources in the transfer chamber 4, improves the cleanliness of the transfer chamber 4, and ensures that the reaction chambers 2 are always in independent processing environments in the semiconductor processing.

As a second aspect of the present disclosure, semiconductor processing equipment is provided and includes the processing chamber of embodiments of the present disclosure.

In the semiconductor processing equipment of the present disclosure, the transfer chamber 4 can include the transfer mechanism 22 and the carrier mechanism 21. The carrier mechanism 21 can temporarily store the to-be-processed wafer 3. Thus, when the current batch of wafers 3 carried by the plurality of bases 8 ascend to the corresponding reaction chambers 2, and the semiconductor processing is performed synchronously, the transfer mechanism 22 can first transfer the next batch of wafers from outside the processing chamber onto the carrier mechanism 21. When the semiconductor processing of the current batch of wafers 3 is ended, the transfer mechanism 22 can transfer the processed wafers 3 out of the processing chamber. Then, the carrier mechanism 21 can transfer the next batch of wafers carried by the carrier mechanism 21 on to the plurality of bases 8. Compared to the existing technology, between the steps of performing the semiconductor processing on the neighboring batches of wafers in the existing technology, the operation time of transferring the next batch of wafers into the processing chamber in sequence and positioning can be adjusted so that the transfer time of the next batch of wafers can overlap the time for performing the semiconductor processing on the current batch of wafers. Thus, the wafer transfer time can be saved, and the equipment capacity can be improved.

Moreover, the transfer and positioning of the wafers can be implemented by the transfer mechanism 22 and the carrier mechanism 21. Thus, no transfer platform with the manipulator needs to be arranged on the outer side of the processing chamber. As a embodiment of the present disclosure, as shown in FIG. 8, one side of the transfer opening 10 of the processing chamber is directly aligned with the loadlock 42. Thus, the overall structure of the semiconductor processing equipment can be more compact, which reduces the area occupied by the equipment and improves the economic benefits of the semiconductor production line.

As an embodiment of the present disclosure, as shown in FIG. 8, the semiconductor processing equipment further includes a front-end module 43 and a plurality of loading platforms 44. The front-end module 43 can include a manipulator. The manipulator can be configured to pick out the wafer in the wafer storage device (e.g., storage box) on the loading platform 44 in an atmosphere environment and place the wafer in the loadlock 42, or transfer the wafer in the loadlock 42 back into the wafer storage device on the loading platform 44. The loadlock 42 can be configured to evacuate the chamber of the loadlock to (close to) vacuum after receiving the wafer. Thus, the transfer mechanism 22 in the transfer chamber 4 can fetch the wafer in the (close to) vacuum environment. The loadlock 42 can be further configured to return to the atmosphere pressure after receiving the wafer transferred by the transfer mechanism 22. Thus, the manipulator of the front-end module 43 can fetch the wafer.

To improve the wafer transfer efficiency, as a embodiment of the present disclosure, as shown in FIG. 4A, FIG. 6, FIG. 7, and FIG. 8, two transfer openings 10 are formed on the side wall of the transfer chamber 4. Two loadlocks 42 are arranged at positions corresponding to the two transfer openings 10 at the outer side of the processing chamber. The transfer mechanism 22 can be configured to obtain the wafters by the two loadlocks 42 through the two transfer openings 10 and transfer the wafers into the two loadlocks 42 through the two transfer openings 10.

As a third aspect of the present disclosure, a semiconductor processing method is provided and applied to the processing chamber of embodiments of the present disclosure. The method includes the following steps.

At S1, the transfer mechanism 22 is controlled to transfer the wafers outside the processing chamber onto the plurality of bases 8.

At S2, the plurality of bases 8 are controlled to ascend into the corresponding reaction chambers 2 and are performed with the semiconductor processing, while the transfer mechanism 22 is simultaneously controlled to transfer the wafers outside the processing chamber onto the carrier mechanism 21.

At S3, after the semiconductor processing is completed, the plurality of bases 8 are controlled to descend into the transfer chamber 4, and the transfer mechanism 22 is controlled to transfer the wafers on the plurality of bases 8 out of the processing chamber.

At S4, the carrier mechanism 21 is controlled to transfer the plurality of wafers carried by the carrier mechanism 21 onto the plurality of bases 8.

Step S2 to step S4 can be repeated.

It should be noted that in step S1, the bases 8 can be at lower positions, and the support columns 11 can extend to be above the carrying surfaces of the bases 8. When the semiconductor processing of the last batch of wafers is performed, only step S2 and step S3 need to be executed. In step S2, the transfer mechanism 22 may not need to be controlled to transfer the wafers from outside the processing chamber to the carrier mechanism 21 (there are no wafers outside the processing chamber waiting to be transferred into the processing chamber).

In the semiconductor processing method of the present disclosure, the transfer chamber 4 can include the transfer mechanism 22 and the carrier mechanism 21. The carrier mechanism 21 can temporarily store the to-be-processed wafer 3. Thus, when the current batch of wafers 3 carried by the plurality of bases 8 ascend to the corresponding reaction chambers 2, and the semiconductor processing is performed synchronously, the transfer mechanism 22 can first transfer the next batch of wafers from outside the processing chamber onto the carrier mechanism 21. When the semiconductor processing of the current batch of wafers 3 is ended, the transfer mechanism 22 can transfer the processed wafers 3 out of the processing chamber. Then, the carrier mechanism 21 can transfer the next batch of wafers carried by the carrier mechanism 21 onto the plurality of bases 8. Compared to the existing technology, between the steps of performing the semiconductor processing on the neighboring batches of wafers in the existing technology, the operation time of transferring the next batch of wafers into the processing chamber in sequence and positioning can be adjusted so that the transfer time of the next batch of wafers can overlap the time for performing the semiconductor processing on the current batch of wafers. Thus, the wafer transfer time can be saved, and the equipment capacity can be improved.

Moreover, the transfer and positioning of the wafers can be implemented by the transfer mechanism 22 and the carrier mechanism 21. Thus, no transfer platform with the manipulator needs to be arranged on the outer side of the processing chamber. One side of the transfer opening 10 of the processing chamber is directly aligned with the loadlock 42. Thus, the overall structure of the semiconductor processing equipment can be more compact, which reduces the area occupied by the equipment and improves the economic benefits of the semiconductor production line.

When the processing chamber includes 4 reaction chambers 2, step S1 can include the following steps.

At S 11, the transfer mechanism 22 is controlled to adjust the height to allow the finger member 221 to be higher than the top of the support column 11, and the to-be-processed wafers 3 are obtained from outside the processing chamber (loadlock 42), the plurality of swing rods of the transfer mechanism 22 are controlled to swing to cause the finger member 221 and the wafer carried by the finger member 221 to move to be above the support columns of the first base 25.

The transfer mechanism 22 is controlled to drive the finger member 221 to descend to cause the to-be-processed wafer 3 to fall onto the support columns 11 and drive the finger member 221 to return to an initial position (e.g., a position between the second base 23 and the fourth base 26 and not interfering with the base 8 and the carrier mechanism 21).

At S12, the transfer mechanism 22 is controlled to adjust the height to allow the finger member 221 to be higher than the top of the support column 11 and obtain the to-be-processed wafer 3 outside the processing chamber (loadlock 42). The plurality of swing rods of the transfer mechanism 22 are controlled to swing to allow the finger member 221 and the wafer carried by the finger member 221 to move to a position above the support column 11 of the second based 23.

The transfer mechanism 22 is controlled to drive the finger member 221 to descend to allow the to-be-processed wafer 3 to fall onto the support columns 11 and drive the finger member 221 to return to the initial position.

At S 13, the transfer mechanism 22 is controlled to adjust the height to allow the finger member 221 to be higher than the top of the support column 11 and obtain the to-be-processed wafer 3 outside the processing chamber (loadlock 42). The plurality of swing rods of the transfer mechanism 22 are controlled to swing to allow the finger member 221 and the wafer carried by the finger member 221 to move to a position above the support column 11 of the third base 24.

The transfer mechanism 22 is controlled to drive the finger member 221 to descend to allow the to-be-processed wafer 3 to fall onto the support columns 11 and drive the finger member 221 to return to the initial position.

At S 14, the transfer mechanism 22 is controlled to adjust the height to allow the finger member 221 to be higher than the top of the support column 11, and obtain the to-be-processed wafer 3 outside the processing chamber (loadlock 42). The plurality of swing rods of the transfer mechanism 22 are controlled to swing to allow the finger member 221 and the wafer carried by the finger member 221 to move to a position above the support column 11 of the fourth base 26.

The transfer mechanism 22 is controlled to drive the finger member 221 to descend to allow the to-be-processed wafer 3 to fall onto the support columns 11, and drive the finger member 221 to return to the initial position.

To avoid mutual scratching and collision between the carrier mechanism 21 and the transfer mechanism 22, step S1 can also include step S10 executed before step S11 of controlling the carrier mechanism 21 to adjust the height to allow the carrier mechanism 21 to be in the carrying position and higher than a highest limit position of the transfer mechanism 22.

In step S2, controlling the transfer mechanism 22 to transfer the wafers outside the processing chamber onto the carrier mechanism 21 can specifically include the following steps.

At S21, the carrier mechanism 21 is controlled to adjust the height to allow the carrier mechanism 21 to be in the transfer position and lower than the highest limit position of the transfer mechanism 22.

At S22, the transfer mechanism 22 is controlled to adjust the height and obtain the to-be-processed wafer 3 to be processed outside the processing chamber (loadlock 42) (as shown in FIG. 6). The transfer mechanism 22 is controlled to ascend to a position where the finger member 221 is higher than the finger piece. The plurality of swing rods of the transfer mechanism 22 are controlled to swing to allow the finger member 221 and the wafer carried by the finger member 221 to move to a position above the finger piece 211 (as shown in FIG. 7).

The transfer mechanism 22 is controlled to drive the finger member 221 to descend to allow the to-be-processed wafer 3 to fall onto the finger pieces 211 and drive the finger member 221 to return to the initial position.

At S23, the transfer mechanism 22 is controlled to adjust the height and obtain the to-be-processed wafer 3 outside the processing chamber. The transfer mechanism 22 is controlled to ascend to a position where the finger member 221 is higher than the finger piece. The plurality of swing rods of the transfer mechanism 22 are controlled to swing to allow the finger member 221 and the wafer carried by the finger member 221 to move to a position above the finger piece 212.

The transfer mechanism 22 is controlled to drive the finger member 221 to descend to allow the to-be-processed wafer 3 to fall onto the finger piece 212 and drive the finger member 221 to return to the initial position.

At S24, the transfer mechanism 22 is controlled to adjust the height and obtain the to-be-processed wafer 3 outside the processing chamber. The transfer mechanism 22 is controlled to ascend to a position where the finger member 221 is higher than the finger piece. The plurality of swing rods of the transfer mechanism 22 are controlled to swing to allow the finger member 221 and the wafer carried by the finger member 221 to move to a position above the finger piece 213.

The transfer mechanism 22 is controlled to drive the finger member 221 to descend to allow the to-be-processed wafer 3 to fall onto the finger piece 213 and drive the finger member 221 to return to the initial position.

At S25, the transfer mechanism 22 is controlled to adjust the height and obtain the to-be-processed wafer 3 outside the processing chamber. The transfer mechanism 22 is controlled to ascend to a position where the finger member 221 is higher than the finger piece. The plurality of swing rods of the transfer mechanism 22 are controlled to swing to allow the finger member 221 and the wafer carried by the finger member 221 to move to a position above the finger piece 214.

The transfer mechanism 22 is controlled to drive the finger member 221 to descend to allow the to-be-processed wafer 3 to fall onto the finger piece 214 and drive the finger member 221 to return to the initial position.

At S26, the carrier mechanism 21 is controlled to return to the carrying position.

To improve the safety of the semiconductor processing chamber, the initial circumferential position of the carrier mechanism 21 can include that each finger piece is located between two neighboring bases 8. That is, when the processing chamber includes four reaction chambers 2, the circumferential angle between two neighboring bases 8 can be 90°, and the circumferential angle between the finger piece and a neighboring base 8 can be 45°. Thus, the base 8 can be prevented from colliding with the finger piece during the ascending and descending process.

To increase the movement space of the finger member 221, step S21 can further include controlling the carrier mechanism 21 to drive the connector to drive the plurality of finger pieces to rotate a predetermined angle (e.g., 15°) counterclockwise. Thus, sufficient movement space can be reserved between the finger piece 211 and the first base 25 for the finger member 221 (the base 8 ascends to the reaction chamber 2, and the finger piece does not contact a thin shaft structure under the base 8). Step S26 can further include controlling the carrier mechanism 21 to drive the connector to drive the plurality of finger pieces to rotate the same predetermined angle clockwise (i.e., the circumferential positions of the plurality of finger pieces are restored).

When the processing chamber includes 4 reaction chambers 2, as an embodiment of the present disclosure, step S4 can specifically include the following steps.

At S41, the transfer mechanism 22 is controlled to drive the connector to drive the plurality of finger pieces and the wafer 3 carried by the plurality of finger pieces to rotate clockwise (45°) to allow the finger piece 211 to be located above the first base 25, the finger piece 212 to be located above the second base 23, the finger piece 213 to be located above the third base 24, and the finger piece 214 to be located above the fourth base 26.

At S42, the transfer mechanism 22 is controlled to drive the connector to drive the plurality of finger pieces to descend to a position where the height is lower the top of the plurality of support columns 11 and higher than the carrying surface of the base 8 to allow the wafer 3 on the finger piece 211 to fall onto the support column 11 of the first base 25, the wafer 3 on the finger piece 212 to fall onto the support column 11 of the second base 23, the wafer of the finger piece 213 to fall onto the support column 11 of the third base 24, and the wafer 3 of the finger piece 214 to fall onto the support column 11 of the fourth base 26.

At S43, the transfer mechanism 22 is controlled to drive the connector to drive the plurality of finger pieces to rotate counterclockwise (45°) to allow the plurality of finger pieces to return to the initial position and drive the connector to drive the plurality of finger pieces to ascend to the carrying position.

It can be understood that the above embodiments are merely exemplary embodiments adopted to illustrate the principles of the present disclosure. However, the present disclosure is not limited to this. For those skilled in the art, various modifications and improvements can be made without departing from the spirit and scope of the present disclosure. These modifications and improvements are also within the scope of the present disclosure.

## Claims

1. A processing chamber applied in semiconductor processing equipment comprising a transfer chamber and a plurality of reaction chambers located above the transfer chamber, wherein the plurality of reaction chambers are all communicatively connected to the transfer chamber through bottom openings, the processing chamber further includes a plurality of bases configured to carry wafers, the plurality of bases are in one-to-one correspondence with positions of the plurality of reaction chambers and are capable of ascending and descending between the reaction chambers and the transfer chamber to seal or open the bottom openings, the processing chamber further includes a transfer mechanism and a carrier mechanism arranged in the transfer chamber, the transfer mechanism is configured to transfer a wafer from outside the processing chamber to the carrier mechanism or onto the base and transfer the wafer on the base out of the processing chamber, and the carrier mechanism is configured to carry and transfer a plurality of wafers to the plurality of bases.

2. The processing chamber according to claim 1, wherein the plurality of bases arranged around the carrier mechanism, the carrier mechanism includes a plurality of wafer-carrying positions, a number of the wafer-carrying positions is consistent with a number of the bases, and the carrier mechanism is configured to allow the plurality of wafer-carrying positions to simultaneously approach the plurality of corresponding bases and transfer the plurality of wafers onto the plurality of corresponding bases, or allow the plurality of wafer-carrying positions to simultaneously away from the plurality of bases.

3. The processing chamber according to claim 2, wherein the carrier mechanism includes a driver, a connector, and a plurality of finger pieces, the wafer-carrying positions are formed on upper surfaces of the finger pieces, the plurality of finger pieces are arranged around the connector, and the driver is configured to drive the connector to ascend and descend the plurality of finger pieces and drive the plurality of finger pieces to rotate around a rotation axis of the connector.

4. The processing chamber according to claim 3, wherein a base includes a plurality of base holes distributed around an axis of the base, and a plurality of support columns are arranged in the plurality of base holes in a one-to-one correspondence, the plurality of support columns are configured to descend relative to the base along the plurality of base holes when the base ascends, ascend with the base after top surfaces of the plurality of support columns are not higher than a carrying surface of the base, and support and lift the wafer on the base after the base descends to bottoms of the plurality of support columns and contacts a bottom wall of the transfer chamber; and
a finger piece includes a clearance on a side of the finger piece facing the corresponding base, and when the driver drives the connector to drive the plurality of finger pieces to rotate to a position above the plurality of bases in one-to-one correspondence to the plurality finger pieces, the plurality of support columns of each base are in the clearance of the corresponding finger piece.

5. The processing chamber according to claim 4, wherein a support column includes a position-limiting member, the position-limiting member cooperates with the base hole and is configured to allow the support column to have a fixed relative position with the base when the base ascends and the top surface of the support column is not higher than the carrying surface of the base to allow the support column to ascend with the base.

6. The processing chamber according to any one of claims 1 to 5, wherein two wafer transfer openings are formed on a side wall of the transfer chamber corresponding to the processing chamber, and the transfer mechanism is configured to obtain the wafer from outside the processing chamber through the two wafer transfer openings and transfer the wafer out of the processing chamber through the two wafer transfer openings.

7. The processing chamber according to any one of claims 1 to 5, where the processing chamber further includes a plurality of sealing rings, the plurality of sealing rings are in one-to-one correspondence with the plurality of bases, the sealing rings are sleeved circumferentially on side walls of the bases, and the sealing rings are able to seal the bottom openings of the corresponding reaction chambers when the bases ascend to the corresponding reaction chambers.

8. The processing chamber according to claim 7, wherein a plurality of sets of annular sealing grooves are formed at a top wall of the transfer chamber in one-to-one correspondence with the bottom openings of the plurality of reaction chambers, a plurality of annular sealing grooves of each set are arranged coaxially and around the corresponding bottom opening, a sealing ring includes an annular positioning surface facing the top wall of the transfer chamber, a plurality of annular protrusions are formed on the annular positioning surface and are arranged coaxially, the plurality of annular protrusions are in one-to-one correspondence with the plurality of annular sealing grooves, when the base ascends to the reaction chamber, the annular protrusions at least partially enter the corresponding annular sealing grooves.

9. The processing chamber according to any one of claims 1 to 5, wherein the transfer mechanism includes a driver, a finger member, and a plurality of swing rods, the plurality of swing rods are sequentially connected between the driver and the finger member, and the plurality of swing rods and the swing rods with the driver and the finger member are articulated through articulation shafts, the plurality of articulation shafts extend vertically, the driver is configured to drive the finger member and the plurality of swing rods to rotate around the articulation shafts, respectively, and drive the plurality of swing rods and the finger member to ascend and descend.

10. Semiconductor processing equipment, wherein the semiconductor processing equipment includes the processing chamber according to any one of claims 1 to 9.

11. A semiconductor processing method applied to the processing chamber according to any one of claims 1 to 9 and comprising:
step S1, controlling the transfer mechanism to transfer the wafers outside the processing chamber onto the plurality of bases;
step S2, controlling the plurality of bases to ascend to the corresponding reaction chambers, and performing semiconductor processing, and simultaneously controlling the transfer mechanism to transfer wafers from outside the processing chamber to the carrier mechanism;
step S3, after the semiconductor processing is completed, controlling the plurality of bases to descend into the transfer chamber, and controlling the transfer mechanism to transfer the wafers on the plurality of bases out of the processing chamber;
step S4, controlling the carrier mechanism to transfer the plurality of wafers carried by the carrier mechanism onto the plurality of bases; and
repeatedly executing steps S2 to S4.
